# EUROPEAN PATENT APPLICATION

(11) **EP 1 994 993 A2**
(43) Date of publication of application: **26.11.2008**
(21) Application number: 08156647.3
(22) Date of filing: 21.05.2008
(51) Int. Cl.: B08B 3/08, H01L 51/00

(54) **Method for cleaning metal mask**

(30) Priority: 22.05.2007 JP 2007135679
(71) Applicant: KABUSHIKI KAISHA TOYOTA JIDOSHOKKI, Kariya-shi, Aichi 448-8671 (JP)
(72) Inventor: Sone, Hirotaka, Kariya-shi Aichi 448-8671 (JP)
(74) Representative: TBK-Patent

(57) **Abstract**

A method for cleaning a metal mask is disclosed. The method includes washing (S1,S2) the metal mask with an organic solvent that dissolves an organic substance adhered to the metal mask, washing (S3), with pure water, the metal mask from which the adhering substance has been removed, and vacuum drying (S4) the metal mask that has been washed with the pure water.

## Description

The present invention relates to a method for cleaning a metal mask, and more specifically to a method for cleaning a metal mask on which organic matter and metal are adhered.

### BACKGROUND ART

As light emitting elements, organic electroluminescence elements (hereinafter, electroluminescence is in some cases abbreviated as EL) have been drawing attention in recent years. Basically, an organic EL element is formed by sequentially laminating an organic EL layer and a cathode on an anode patterned on a substrate. The layers configuring the organic EL element are patterned on the substrate using a shadow mask by a dry process such as vacuum deposition.

The shadow mask for the patterning of the organic EL layer is repeatedly used. Accordingly, organic compounds accumulate on part of the shadow mask facing to a deposition source side. As a result, the following problems occur. That is, the opening area of an opening portion formed in the shadow mask is substantially reduced. Also, the thickness of part of the shadow mask around the opening portion is substantially increased. As a result, the amount of the organic compounds that fly toward the substrate at an angle and become adhered to the substrate changes in accordance with the number of times the shadow mask is used. Furthermore, particles are generated from the organic compounds that are accumulated on the shadow mask, and the particles cause defects in a light emitting layer of the organic EL layer. Like the shadow mask for the organic EL layer, an electrode material is accumulated also on a shadow mask used for patterning the cathode by repeatedly using the mask. As a result, the shadow mask for cathode also has the same problems as the shadow mask for organic EL layer.

In order to enable repeated performance of high accuracy patterning using the shadow mask for organic EL layer and the shadow mask for cathode, the shadow masks need to be regenerated by some means so as to enable patterning as desired. Thus, a method has been proposed that washes a shadow mask on which compounds and electrode material are accumulated so as to regenerate the shadow mask. Japanese Laid-Open Patent Publication No. 2001-203079 discloses a technique for washing a shadow mask for light emitting layers using an organic solvent. As an embodiment, a method has been disclosed in which the shadow mask for light emitting layers is washed with acetone, dichloromethane, or an isopropyl alcohol, and then dried. The publication also discloses a technique for washing a shadow mask for electrodes. The publication discloses that the shadow mask for electrodes is preferably washed with an acid or alkaline solution when a metal material forming the electrode (for example, aluminum) is adhered to the shadow mask for electrodes. As an embodiment, a method has been disclosed in which the shadow mask for electrodes is soaked in a 0.5 Normal caustic soda solution. After the solution is stirred in this state, the shadow mask is water washed and dried.

The shadow mask for light emitting layers that has been washed with the organic solvent is washed using an isopropyl alcohol, ethanol, or the like in the final washing, but is not washed using water. This is because, the organic EL layer is susceptible to moisture and oxygen. However, in a case where the shadow mask is washed using alcohol in the final washing, traces of alcohol might remain on the shadow mask after drying. Thus, alcohol is not preferred.

The shadow mask for electrodes is washed with water after being washed with an acid or alkaline solution. The shadow mask for electrodes that has been washed with water is easily deformed, distorted, or stained with water marks (moisture stains) depending on drying conditions. Also, since the shadow mask for electrodes is generally made of metal, rust becomes a problem. The shadow mask for electrodes is particularly susceptible to rust if the shadow mask is formed of invar, which is a metal having only a small difference in the coefficient of thermal expansion compared to the glass substrate.

However, the above publication does not mention about any method for solving the problem caused by washing and drying the shadow mask.

Accordingly, it is an objective of the present invention to provide a method for cleaning a metal mask that does not leave traces such as stains, suppresses deformation and distortion of the mask, and does not easily cause rust.

To achieve the above objective, the present invention provides a method for cleaning a metal mask. The method includes washing the metal mask with an organic solvent that dissolves an organic substance adhered to the metal mask, washing, with pure water, the metal mask from which the adhering substance has been removed, and vacuum drying the metal mask that has been washed with the pure water.

### BRIEF DESCRIPTION OF THE DRAWINGS

Fig. 1 is a flowchart showing a procedure of a method for cleaning a metal mask according to a first embodiment of the present invention;
Fig. 2A is an exploded schematic perspective view illustrating the metal mask;
Fig. 2B is a schematic perspective view illustrating the metal mask of Fig. 2A; and
Fig. 3 is a flowchart showing a procedure of a method for cleaning a metal mask according to a second embodiment of the present invention.

### DESCRIPTION OF THE PREFERRED EMBODIMENT

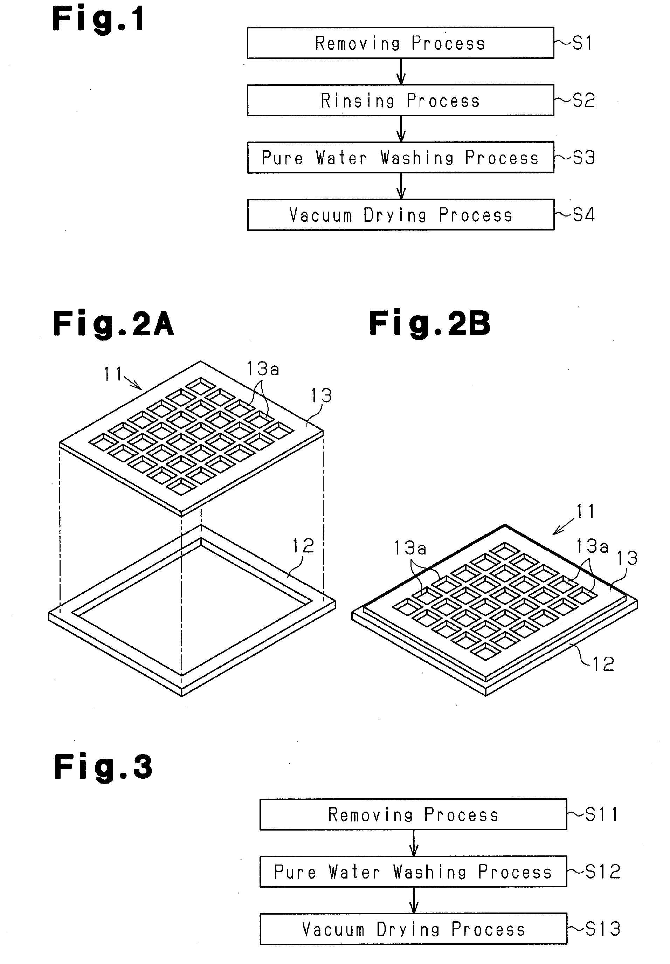

A method for cleaning a metal mask 11 according to a first embodiment of the present invention will now be described with reference to Figs. 1 to 2B. The metal mask 11 of the first embodiment is a shadow mask used when depositing, on a substrate, a hole transport layer, a light emitting layer, an electron transport layer, or the like which configures an organic EL layer of an organic EL element.

As shown in Figs. 2A and 2B, the metal mask 11 includes a mask frame 12 and a mask main body 13, which is provided with openings 13a. The mask main body 13 is fixed to the mask frame 12 by welding in a state where tension is applied to the mask main body 13. The thickness of the mask main body 13 is, for example, 10 to 200 µm.

The metal mask 11 is formed of metal having a small thermal expansion coefficient, such as invar. The invar is an alloy of nickel (Ni) and iron (Fe), and includes 36 weight % of nickel (Ni). The remainder is substantially iron (Fe).

The metal mask 11 is used in a deposition chamber of an apparatus for manufacturing the organic EL element. Therefore, as the metal mask 11 is repeatedly used, adhering substances, which are organic substances (organic compounds) in the first embodiment, accumulate at part of the mask main body 13 facing a deposition source provided in the deposition chamber. When the number of times the metal mask 11 is used (number of deposition processes) reaches a predetermined number of times, a process for removing the organic substances accumulated on the metal mask 11, that is, a process for cleaning the metal mask 11 is performed. The predetermined number of times is specified as follows. That is, experiments are performed in advance to determine the number of times the metal mask 11 is used upon which the accumulation amount of the organic substances on the metal mask 11 hinders patterning as designed. A value that is less than the number of times obtained through the experiments is set as the predetermined number of times.

A method for cleaning the metal mask 11 by removing the organic substances accumulated on the metal mask 11 will now be described with reference to the flowchart of Fig. 1.

The cleaning method includes a removing process, a rinsing process, a pure water washing process, and a vacuum drying process.

In the removing process of step S1, the organic substances accumulated on the metal mask 11 are dissolved using an organic solvent which is a solvent capable of dissolving the organic substances. As a method for dissolving and removing the organic substances, a method is known in which the metal mask 11 is soaked in the organic solvent for a predetermined time period in a state where part of the metal mask 11 on which the organic substances are accumulated faces downward. At this time, the metal mask 11 may be simply left soaked in the organic solvent, or the organic solvent may be stirred. If the metal mask 11 is soaked in the organic solvent in a state where part of the metal mask 11 on which the organic substances are accumulated is caused to face upward, the dissolved organic substances might adhere to the metal mask 11 again. Thus, the metal mask 11 is preferably soaked in the organic solvent in a state where the part on which the organic substances are accumulated is caused to face downward.

In the rinsing process of step S2, the metal mask 11 from which the organic substances have been removed in the removing process is soaked in an organic solvent that easily mix with water, or is showered using the organic solvent. As for the organic solvent that easily mixes with water, for example, an isopropyl alcohol or ethanol is used. The objective of the rinsing process is to make a residual organic solvent adhered to the metal mask 11 to be easily washed away with pure water in the subsequent pure water washing process even if the organic solvent used in the removing process has the property that does not easily mix with water. The rinsing process changes the organic solvent to an organic solvent that easily mix with water even if the organic solvent used in the removing process does not easily mix with water.

In the pure water washing process (final washing process) of step S3, pure water is sprayed onto the metal mask 11 to wash the metal mask 11. The jet pressure of the pure water and the washing time period are set to a pressure and a time period at which the mask main body 13 does not deform. For example, the jet pressure is set to 1 to 6 kg/cm², and the washing time period is set to about five minutes.

In the vacuum drying process of step S4, the metal mask 11 is arranged in a vacuum dryer and is dried in vacuum to remove pure water adhered to the metal mask 11 after the pure water washing process. Since the metal mask 11 easily rusts, moisture is preferably removed from the metal mask 11 in a short period of time to prevent generation of rust. On the assumption that the pressure in the vacuum dryer during vacuum drying is not changed, the higher the temperature inside the vacuum dryer (drying temperature) is, the shorter the time required for drying (drying time period) becomes. However, when the metal mask 11 is heated, depending on the temperature during heating, the mask main body 13 might be significantly extended or distorted by an amount that hinders the patterning accuracy of the metal mask 11 after drying. Therefore, the drying temperature needs to be set in the appropriate temperature range. The drying time period is also associated with distortion of the mask main body 13. The drying time period is preferably short.

However, if the drying time period is too short, a stain of moisture (water mark) is generated on the metal mask 11 after drying, which is undesirable. Therefore, the drying temperature is preferably in the range of 20 to 70°C, and the drying time period is preferably about 5 to 60 minutes. That is, the degree of vacuum in the vacuum dryer is preferably set such that drying of the metal mask 11 is completed with the drying temperature in the range of 20 to 70°C and the drying time period of 5 to 60 minutes.

When the metal mask 11 is vacuum dried, a dry gas is introduced into the vacuum dryer so that the inside of the vacuum dryer returns to atmospheric pressure from a decompressed state (vacuum state).

As a result of reusing the metal mask 11 that has been regenerated by the above mentioned cleaning process as a shadow mask for forming the layers configuring the organic EL layer through deposition, high precision patterning was performed.

Tables 1 and 2 show experimental results obtained by performing vacuum drying on the metal mask 11 which had been subjected to the pure water washing process, while changing the drying temperature and time under the same degree of vacuum (0.1 kPa).

**[Table 1]**

| Test No. | Degree of Vacuum [kPa] | Temperature [°C] | Time [min] | State of Metal Mask |
|---|---|---|---|---|
| 1 | 0.1 | 20 | 3 | Stain, Residual Moisture |
| 2 | 0.1 | 20 | 5 | No Abnormality |
| 3 | 0.1 | 20 | 15 | No Abnormality |
| 4 | 0.1 | 20 | 30 | No Abnormality |
| 5 | 0.1 | 20 | 60 | No Abnormality |
| 6 | 0.1 | 20 | 120 | Curved, Stain |
| 7 | 0.1 | 20 | 180 | Curved, Stain |
| 8 | 0.1 | 30 | 3 | Normal Appearance, Residual Moisture |
| 9 | 0.1 | 30 | 5 | No Abnormality |
| 10 | 0.1 | 30 | 15 | No Abnormality |
| 11 | 0.1 | 30 | 30 | No Abnormality |
| 12 | 0.1 | 30 | 60 | No Abnormality |
| 13 | 0.1 | 30 | 120 | Curved, Stain |
| 14 | 0.1 | 30 | 180 | Curved, Stain |
| 15 | 0.1 | 50 | 3 | Normal Appearance, Residual Moisture |
| 16 | 0.1 | 50 | 5 | No Abnormality |
| 17 | 0.1 | 50 | 15 | No Abnormality |
| 18 | 0.1 | 50 | 30 | No Abnormality |
| 19 | 0.1 | 50 | 60 | No Abnormality |
| 20 | 0.1 | 50 | 120 | Curved, Stain |
| 21 | 0.1 | 50 | 180 | Curved, Stain |

**[Table 2]**

| Test No. | Degree of Vacuum [kPa] | Temperature [°C] | Time [min] | State of Metal Mask |
|---|---|---|---|---|
| 22 | 0.1 | 70 | 3 | Normal Appearance, Residual Moisture |
| 23 | 0.1 | 70 | 5 | No Abnormality |
| 24 | 0.1 | 70 | 15 | No Abnormality |
| 25 | 0.1 | 70 | 30 | No Abnormality |
| 26 | 0.1 | 70 | 60 | No Abnormality |
| 27 | 0.1 | 70 | 120 | Curved, Stain |
| 28 | 0.1 | 70 | 180 | Curved, Stain |
| 29 | 0.1 | 80 | 3 | Normal Appearance, Residual Moisture |
| 30 | 0.1 | 80 | 5 | No Abnormality |
| 31 | 0.1 | 80 | 15 | No Abnormality |
| 32 | 0.1 | 80 | 30 | Normal Appearance, Expansion & Contraction during Heating |
| 33 | 0.1 | 80 | 60 | Expansion, Stain |
| 34 | 0.1 | 80 | 120 | Expansion |
| 35 | 0.1 | 80 | 180 | Expansion |
| 36 | 0.1 | 110 | 3 | Normal Appearance, Residual Moisture |
| 37 | 0.1 | 110 | 5 | Normal Appearance, Expansion & Contraction during Heating |
| 38 | 0.1 | 110 | 15 | Normal Appearance, Expansion & Contraction during Heating |
| 39 | 0.1 | 110 | 30 | Normal Appearance, Expansion & Contraction during Heating |
| 40 | 0.1 | 110 | 60 | Expansion |
| 41 | 0.1 | 110 | 120 | Expansion |
| 42 | 0.1 | 110 | 180 | Expansion |

The term "Expansion" in Tables 1 and 2 means that the metal mask 11 was thermally expanded and deformed. In Tables 1 and 2, "Stain" means that a water mark was generated. "Curved" means that a thin plate portion of the mask main body 13 was curved. Also, "Residual Moisture" means there was a high possibility that moisture remains between the mask main body 13 and the mask frame 12. Furthermore, "Expansion & Contraction during Heating" means there was a high possibility that the mask frame 12 and the mask main body 13 are thermally expanded during heating.

As shown in Tables 1 and 2, no abnormality was found in the metal mask 11 after drying in test No. 2-5, 9-12, 16-19, 23-26, 30 and 31, and an abnormality was found in the metal mask 11 after drying in other tests. Therefore, when the drying temperature was set to 20 to 70°C and the drying time period was set to 5 to 60 minutes, the metal mask 11 were dried without causing distortion or generating stains on the mask main body 13.

The first embodiment has the following advantages.
(1) The method for cleaning the metal mask 11 includes the removing process for washing the metal mask 11 with the solvent that dissolves the adhering substances adhered to the metal mask 11, the pure water washing process for washing, with pure water, the metal mask 11 from which the adhering substances have been removed, and the vacuum drying process for vacuum drying the metal mask 11 that has been washed with the pure water. Thus, the metal mask 11 after washing and drying has no traces such as stains, has minimum deformation and distortion, and does not easily rust. Since the metal mask 11 can be repeatedly used while maintaining high accuracy, costs are reduced as compared to a case where a new metal mask 11 is manufactured. Also, as compared to a case where the metal mask 11 is reused by re-covering the mask frame 12 with the mask main body 13, the metal mask 11 becomes available for reuse in a short period of time.
(2) After dissolving the organic substances adhered to the metal mask 11 with the organic solvent, the metal mask 11 is washed with pure water. Thus, after drying the metal mask 11, traces are not easily formed on the metal mask 11. Also, since the organic solvent is not used in the final washing, costs for handling a waste solvent after washing is reduced.
(3) The rinsing process, which uses the organic solvent that easily mix with water, is performed between the removing process and the pure water washing process. Therefore, even if the organic solvent used in the removing process is a solvent that does not easily mix with water, the organic solvent adhered to the metal mask 11 is efficiently washed away in the pure water washing process.
(4) The metal mask 11 is formed of invar. The invar is suitable for material of the metal mask since its coefficient of thermal expansion is close to that of a glass substrate, which is a substrate of the organic EL element, but is susceptible to rust. However, by vacuum drying the metal mask 11 which has been washed with pure water, formation of rust on the metal mask 11 is suppressed.
(5) Since the drying temperature in the vacuum drying process is set to 20 to 70°C, and the drying time period is set to 5 to 60 minutes, the metal mask 11 is dried without leaving traces such as stains, causing deformation and distortion of the mask, or forming rust.

A method for cleaning the metal mask 11 according to a second embodiment of the present invention will now be described with reference to Fig. 3. The configuration of the metal mask 11 of the second embodiment is the same as that of the first embodiment, but the second embodiment is associated with a method for washing the metal mask 11 used for forming an electrode layer. The method for cleaning the metal mask 11 according to the second embodiment does not include the rinsing process of the first embodiment.

Metal (for example, aluminum, silver, and lithium fluoride) forming the electrode layer adheres to the metal mask 11 used in the patterning of the electrode layer as the adhering substances. According to the second embodiment, in the removing process of step S11, the metal adhered to the metal mask 11 is dissolved and removed using a solution that dissolves the metal. As the solution for dissolving the metal, for example, an acid aqueous solution, preferably a strong acid aqueous solution is used. After removing the metal adhered to the metal mask 11, the metal mask 11 is washed with pure water in the pure water washing process of step S12. Washing conditions of the pure water washing process of step S12 are the same as the washing conditions of the pure water washing process of step S3 according to the first embodiment. The drying conditions of the vacuum drying process of step S13 are the same as the drying conditions of the vacuum drying process of step S4 according to the first embodiment.

The second embodiment has the following advantages in addition to the advantages (1), (4), and (5) of the first embodiment.
(6) Since the solution used in the removing process is the acid aqueous solution (preferably, the strong acid aqueous solution), it is not necessary to provide the rinsing process, which uses an organic solvent that easily mix with water, between the removing process and the pure water washing process.

The present invention is not limited to the above embodiments and may be modified as follows.

In the first embodiment, the metal mask 11 may be washed using a mixed solution formed by mixing multiple types of organic solvents, or the metal mask 11 may be sequentially soaked in multiple types of organic solvents. Since multiple types of organic substances are adhered to the metal mask 11, it is difficult to dissolve all the organic substances with a single type of organic solvent in some cases. However, by using organic solvents each having excellent dissolving power for different one of the organic substances, the multiple types of organic substances adhered to the metal mask 11 are efficiently dissolved.

In the first embodiment, the rinsing process may be omitted. In a case where the organic solvent used in the removing process is an organic solvent that easily mix with water, omitting the rinsing process has no adverse effect on the washing efficiency of the metal mask 11.

In the second embodiment, if the electrode is an aluminum, the solution used in the removing process may be a weak acid aqueous solution, or may be an alkali aqueous solution.

In the second embodiment, when dissolving the metal adhered to the metal mask 11, antiseptic may be added to the acid aqueous solution to prevent the metal mask 11 from being corroded by the acid aqueous solution.

The material of the metal mask 11 does not need to be invar, but may be other metal, such as kovar, stainless-steel (for example, SUS430), and the like.

The mask frame 12 and the mask main body 13 of the metal mask 11 may be formed of different materials.

The metal mask 11 is not limited to the configuration in which the mask main body 13, which is a separate member, is fixed to the mask frame 12. The mask frame 12 and the mask main body 13 may be configured as an integral object. However, the mask main body 13 needs to be thin to increase the pattern accuracy, but the mask frame 12 cannot be made too thin to secure the strength. Therefore, by fixing the separately formed mask frame 12 and mask main body 13 with each other to form the metal mask 11, the metal mask 11 that satisfies the accuracy and the strength is easily formed.

Regarding the metal mask 11, the mask main body 13 does not need to be fixed to the mask frame 12.

An air-blow drying process may be provided between the pure water washing process and the vacuum drying process.

In the pure water washing process, a process for washing the metal mask 11 with ultrapure water may be provided after washing the metal mask 11 with pure water.

In the removing process of each of the above embodiments, instead of soaking the metal mask 11 in the solvent for a predetermined time period, the metal mask 11 may be showered with the solvent.

The degree of vacuum, the drying temperature, and drying time period in the vacuum drying process are not limited to the conditions in the above embodiments as long as traces such as stains are not left on the mask after drying, deformation and distortion of the mask do not easily occur, and the mask does not easily rust. For example, the degree of vacuum may be set to a value other than 0.1 kPa, or the degree of vacuum and the drying temperature may be varied in several steps. In a case where the degree of vacuum is increased, the drying time period is reduced when the drying temperature is not changed, and the drying temperature is reduced when the drying time period is not changed.

A method for cleaning a metal mask is disclosed. The method includes washing the metal mask with an organic solvent that dissolves an organic substance adhered to the metal mask, washing, with pure water, the metal mask from which the adhering substance has been removed, and vacuum drying the metal mask that has been washed with the pure water.

## Claims

1. A method for cleaning a metal mask (11), comprising:
washing the metal mask (11) with a solvent that dissolves an adhering substance adhered to the metal mask (11) ;
washing, with pure water, the metal mask (11) from which the adhering substance has been removed; and
vacuum drying the metal mask (11) that has been washed with the pure water.

2. The method according to claim 1, wherein the degree of vacuum during the vacuum drying is set such that the drying of the metal mask (11) is completed with a drying temperature in the range of 20 to 70°C and a drying time period of 5 to 60 minutes.

3. The method according to claim 1 or 2, wherein the adhering substance is an organic substance.

4. The method according to any one of claims 1 to 3, wherein the metal mask (11) is formed of invar.

5. The method according to any one of claims 1 to 4, wherein the solvent is a mixed solution of multiple types of organic solvents.

6. The method according to any one of claims 1 to 4, wherein washing the metal mask (11) with the solvent includes sequentially soaking the metal mask (11) in multiple types of organic solvents.
